# EUROPÄISCHE PATENTSCHRIFT

(11) **EP 1 676 350 B1**
(45) Veröffentlichungstag und Bekanntmachung des Hinweises auf die Patenterteilung: **09.12.2009**
(21) Anmeldenummer: 04790726.6
(22) Anmeldetag: 21.10.2004

(54) **AKTIVE SCHUTZSCHALTUNGSANORDNUNG**
ACTIVE PROTECTION CIRCUIT ARRANGEMENT
SYSTEME ACTIF DE CIRCUIT DE PROTECTION

(30) Priorität: 21.10.2003 DE 10349405
(43) Veröffentlichungstag der Anmeldung: 05.07.2006
(73) Patentinhaber: austriamicrosystems AG, 8141 Unterpremstätten (AT)
(72) Erfinder: FANKHAUSER, Bernd, A-8010 Graz (AT); MAYERHOFER, Michael, A-8010 Graz (AT)
(74) Vertreter: Epping - Hermann - Fischer
(86) Internationale Anmeldenummer: PCT/EP2004/011925
(87) Internationale Veröffentlichungsnummer: WO 2005/041375

(56) Entgegenhaltungen:
- EP-A- 0 573 213
- WO-A-02/29950
- US-A- 5 559 659
- US-A- 5 617 283
- PATENT ABSTRACTS OF JAPAN Bd. 2003, Nr. 06, 3. Juni 2003 (2003-06-03) & JP 2003 037493 A (DENSO CORP), 7. Februar 2003 (2003-02-07)

## Beschreibung

Die Erfindung betrifft eine Schaltungsanordnung zum Schutz von integrierten Halbleiterschaltungen vor elektrischen Pulsen oder elektrischen Überspannungen.

Derartige Pulse oder Überspannungen können beispielsweise bei sogenannten elektrostatischen Entladungen auftreten (englisch: ESD, Electrostatic Discharge). Die elektrostatischen Entladungen können zu Schäden an integrierten elektronischen Schaltkreisen bis hin zu deren Totalzerstörung führen.

Aktive ESD-Schutzschaltungen für verschiedenste Anwendungen gewinnen zunehmend an Bedeutung, z.B. in der Automobiltechnik. Hier besteht das Erfordernis, derartige Schaltungen auch für deutlich höhere ESD-Pegel als bisher üblich auszulegen. Aktive ESD-Schutzschaltungen werden meistens durch den Anstieg des ESD-Signals getriggert. Der Spannungsanstieg pro Zeiteinheit wird dabei detektiert und über eine Ansteuerschaltung ein Schutztransistor durchgeschaltet.

Aus der US 6,465,768 ist ein ESD-Schutzmittel in integrierter Schaltungstechnik mit einem n-Kanal MOS-Feldeffekttransistor und einem parasitären npn-Bipolartransistor bekannt, dessen Kollektor-Emitter-Strecke parallel zum NMOS-Transistor geschaltet ist. Weiterhin ist eine p-Wanne mit einem Bias-Schaltkreis vorgesehen, der bei Auftreten eines ESD-Pulses einen triggernden Substratstrom auslöst, welcher wiederum den parasitären Bipolar-Junction-Transistor durchschaltet, so daß eine ESD-Überspannung an einem I/O-Pin des Schaltkreises schnell abgeleitet wird. Oft ist gewünscht, nicht nur ein separates I/O-Pad vor ESD-Einwirkung zu schützen, sondern auch die Versorgungsleitung selbst.

Aus der US 5,559,659 ist eine aktive Schutzschaltungsanodnung bekannt, die ein RC-Element umfasst, welches eine nachgeschaltete Inverterkette triggert, die einen Schutztransistor ansteuert. Im Fehlerfall, also bei Vorliegen einer unzulässig hohen Spannung, wird diese Überspannung durch den Schutztransistor gegen Masse abgeleitet und so nachfolgende Baugruppen vor der hohen Spannung schützt. Der Transistor kann demnach als aktiv getriggerter Überspannungsableiter verstanden werden.

Bei ESD-Schaltungen können verschiedene Probleme auftreten. Einerseits ist es nicht erwünscht, daß der Schutztransistor beim Hochfahren der Spannung (power-on) des Schaltkreises aktiviert wird. Das kann bei entsprechender Dimensionierung der ESD-Schaltung z.B. geschehen aufgrund eventuell auftretender, steiler Signalflanken der Versorgungsspannung oder auch bereits, weil die Anstiegszeit der Spannung auf der Versorgungsleitung nicht ausreichend langsamer ist als die Anstiegszeit eines ESD-Pulses. Dann benötigt man einen größeren Strom während der Hochfahrzeit, um die aktive Schutzschaltung wieder auszuschalten.

Ein weiteres Problem kann im Fall eines unerwünschten Ansprechens der ESD-Schaltung beim Hochfahren der Spannung (power-up) des Schaltkreises dadurch entstehen, dass aufgrund des so aktivierten Schutztransistors in unerwünschter Weise die Versorgungsspannung einbricht oder zumindest die Anstiegszeit verlangsamt wird. Dadurch wiederum wird der Schutztransistor hochohmig und kann ganz abschalten. Das darauf folgende schnelle Ansteigen der Versorgungsspannung kann, wie leicht vorstellbar ist, dazu führen, dass auf der Versorgungsleitung ein Schwing- oder Kippeffekt auftritt. Dieses nachteilhafte Verhalten beim Einschalten der Versorgungsspannung kann auch im Normalbetrieb durch elektromagnetische Störeinkopplungen ausgelöst werden. Die Schwing- oder Kippeffekte wiederum führen zu langen Einschaltzeiten des integrierten Schaltkreises, die unerwünscht sind, weil geringe Einschaltzeiten ein bedeutender Aspekt der Produktspezifikation sind und somit einen Wettbewerbsvorteil darstellen. Auch führen die Schwing- oder Kippeffekte zu einer geringeren EMC-Fähigkeit des Produkts.

Im Betrieb der Schaltung kann ein "ripple", also eine kurze Störung der Versorgungsspannung, als ESD-Ereignis gewertet werden und ein Einschalten des Schutztransistors bewirken. Dadurch fließt kurzzeitig Strom von der VDD-Leitung weg durch den Schutztransistor, was den ripple zu einer größeren Störung macht. Eine Abhilfe durch externes Stützen der Versorgung erhöht den Aufwand.

Es kann weiter vorgesehen sein, bei Tests der Funktionsfähigkeit von zu schützenden Schaltungen auf elektromagnetische Verträglichkeit (EMV oder EMC(Electromagnetic Compatibility)) EMC-Testsignale als Störsignale einzusetzen. Wenn die Schutzschaltungsanordnung auf diese schnellen Störsignale zu empfindlich reagiert, kann die Schutzschaltung aktiviert werden und ein erneutes Hochfahren der Versorgungsspannung (power-on-reset) auslösen. Dies bedeutet einen Fehlzustand der EMC-Charakterisierung.

Der Erfindung liegt die Aufgabe zugrunde, eine aktive Schutzschaltung anzugeben, die ein demgegenüber verbessertes Ansprechverhalten zeigt.

Diese Aufgabe löst die Erfindung mit den Merkmalen des Patentanspruchs 1. Vorteilhafte Ausgestaltungen und Weiterbildungen der Erfindung sind Gegegnstand der abhängigen Ansprüche.

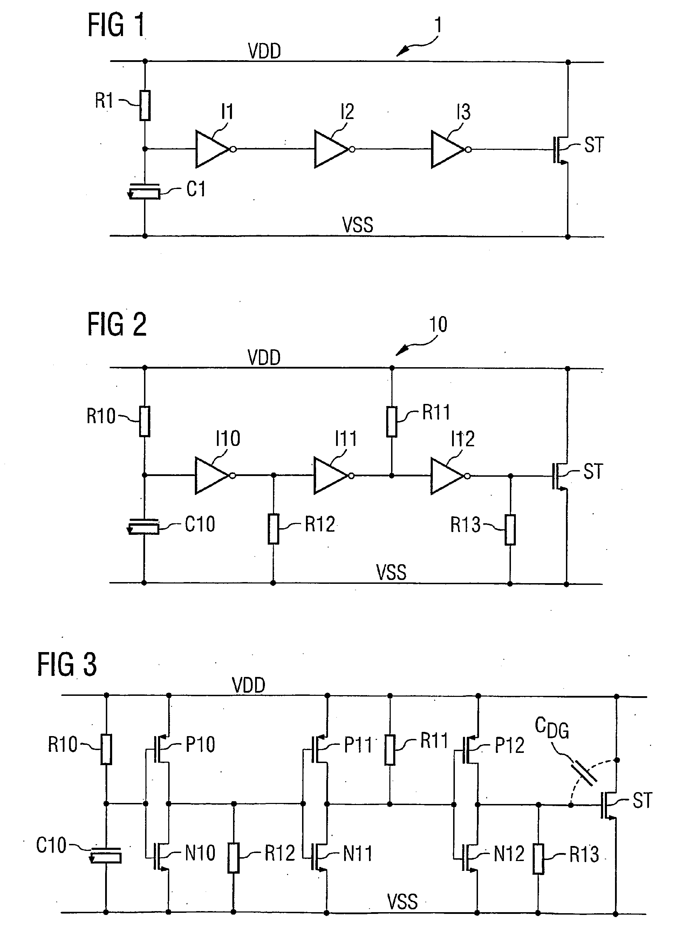

Die Erfindung wird im folgenden anhand von Ausführungsbeispielen im Zusammenhang mit den Figuren 1 und 2 näher erläutert.

Es zeigen
- Figur 1: eine bereits erwähnte schematisch dargestellte Schutzschaltungsanordnung nach dem Stand der Technik,
- Figur 2: eine schematisch dargestellte Schutzschaltungsanordnung mit verbesserten Eigenschaften und.
- Figur 3: die Schutzschaltungsanordnung nach Figur 2 mit CMOS-Invertern.

Gleiche oder gleichwirkende Elemente sind in den Figuren mit gleichen Bezugszeichen versehen.

Gemäß Figur 1 ist die bekannte aktive Schutzschaltung 1 an eine Leitung VDD mit Versorgungspotential und eine Leitung VSS mit Bezugspotential angeschlossen. Zwischen VDD und VSS liegt somit die Versorgungsspannung. Parallel zu dieser Schutzschaltung kann einerseits eine Eingangsschaltung und/oder andererseits eine zu schützende Nutzschaltung angeschlossen sein, die in der Figur nicht dargestellt sind. Die Eingangsschaltung kann auch einfach ein mit VDD verbundener Anschluss (pad) sein.

Der Widerstand R1 bildet mit der Kapazität C1 ein RC-Glied. Bevorzugt ist der Widerstand R1 als Diffusionswiderstand und die Kapazität C1 als Oxid- bzw. Gateoxidkapazität ausgebildet.

Beim Auftreten eines ESD-Pulses oder einer EMC-Störung triggert das RC-Glied aus R1 und C1 eine nachgeschaltete Inverterkette aus den seriell hintereinander geschalteten Invertern I1, I2 und I3. Ein Inverter invertiert das an seinem Eingang anliegende Signal und stellt dieses an seinem Ausgang bereit. Der Ausgang von I3 ist mit dem Steuereingang eines Schutztransistors ST so verbunden, dass der Inverter den Schutztransistor ST durchschalten kann, um das Störsignal auf der Leitung VDD gegen Bezugspotential VSS abzuleiten. Die Anzahl der Inverter ist dabei unter anderem auf den Kanaltyp des Schutztransistors ST so abgestimmt, dass dieser bei einem ESD-Puls oder einer EMC-Störung durchschaltet. Der Schutztransistor ST ist in seiner Dimensionierung so groß ausgelegt, dass er die an VDD auftretenden Störsignale ableiten kann.

Als grobe Dimensionierungsregel gilt, dass die Schaltung 1 so ausgelegt sein soll, dass die maximale Anstiegszeit von Nutzsignalen auf der Leitung VDD, beispielsweise beim Einschaltvorgang der Spannungsanstieg der Versorgungsspannung, etwa tausend mal langsamer sein soll als die Anstiegszeit des ESD- oder EMC-Pulses ist.

Wenn bei einer Schaltung gemäss Figur 1 die eingangs genannten Probleme des unerwünschten Einschaltens der Schutzschaltung oder der Schwing- bzw. Kippeffekte auftreten, kann die Schaltung wie in Figur 2 beschrieben und gezeigt verbessert werden.

Gemäß Figur 2 weist die Schutzschaltungsanordnung 10 ebenfalls eingangsseitig ein RC-Glied aus dem Widerstand R10 und der Kapazität C10 auf. Beide Elemente können wie R1 und C1 als Diffusionswiderstand bzw. Oxidkapazität ausgebildet sein. Eine von dem RC-Glied aus R10 und C10 getriggerte Inverterkette aus den in Serie geschalteten Invertern I10, I11 und I12 steuert ausgangsseitig den Schutztransistor ST als Ableitungstransistor an.

Gemäss der Erfindung können mit zweckentsprechend dimensionierten und an geeigneter Stelle in die oben beschriebene ESD-Schutzschaltung, insbesondere die Inverterkette, eingebrachten Pull-Up- und Pull-Down-Widerständen die beschriebenen Probleme wie Schwingneigung und EMC-Überempfindlichkeit beseitigt werden. Die Pull-Up- und Pull-Down-Widerstände sind dabei gegen Versorgungspotential und/oder Bezugspotential geschaltet. Dadurch wiederum kann die Einschaltgeschwindigkeit so geschützter Schaltkreise im Hinblick auf ein Hochfahren der Versorgungsspannung erhöht werden.

Im konkreten Ausführungsbeispiel der Figur 2 bedeutet das, dass der Widerstand R11 zwischen VDD und den Verbindungspunkt von I11 und I12 geschaltet ist. Andererseits ist der Widerstand R12 zwischen VSS und den Verbindungspunkt von I10 und I11 geschaltet, während der Widerstand R13 zwischen VSS und den Verbindungspunkt von I12 und das Gate von ST geschaltet ist. Wenn R10 mit etwa 1 MOhm dimensioniert ist, betragen im Ausführungsbeispiel die Widerstandswerte von R11 bis R13 etwa jeweils 5 kOhm.

Es hat sich gezeigt, dass die gemäss Figur 2 angeordneten Pull-Up- und Pull-Down-Widerstände R11, R12 und R13 eine beschriebene Schwing- oder Kippneigung der Schaltung nach Figur 1 stark verringern und die EMC-Fähigkeiten der Schaltung deutlich verbessern. Das bedeutet, dass für einen sicheren Betrieb der Schaltung 10 die Anstiegszeit der Spannungsversorgung bei power-on nur noch etwa einhundert mal langsamer zu sein braucht als die Anstiegszeit des ESD-Pulses oder des EMC-Störsignals. Im Vergleich zu Schaltung 1 der Figur 1 heisst das eine um den Faktor 10 schnellere zulässige Anstiegszeit des power-on-Nutzsignals beim Einschalten der Nutzschaltung. Mit dieser Verbesserung lassen sich gleichzeitig das Design und die Spezifikationen der Nutzschaltung des Produkts verbessern.

Gemäß der besonderen Ausführungsform der Figur 3 sind die Inverter als CMOS-Inverter mit je einem p-Kanal-Transistor und einem n-Kanal-Transistor ausgebildet. Der p-Kanal-Transistor P10 bildet zusammen mit dem n-Kanal-Transistor N10 den ersten Inverter. Entsprechendes gilt für den Inverter aus P11 und N11 sowie aus P12 und N12. Die Widerstände R11 bis R13 können wie in Figur 2 bevorzugt als Diffusionswiderstände ausgebildet sein.

Das Einschalten der CMOS-Inverter wird im Wesentlichen von dem Schwellwert der jeweiligen Transistor-Paarung bestimmt. Dieser Schwellwert liegt bei CMOS-Invertern typisch bei der halben Versorgungsspannung und damit vergleichsweise hoch. Dadurch ist die Schaltung unempfindlich gegenüber Versorgungsschwankungen wie ripple. Umgekehrt ist eine ausgeprägte ripple-Störung notwendig, um den Schutztransistor durchzuschalten.

In Figur 3 ist die parasitäre Drain-zu-Gate-Kapazität C_{DG} des Schutztransistors ST eingezeichnet. Über diese Kapazität können Störungen direkt auf das Gate von ST gekoppelt werden. Im Fall des Ausführungsbeispiels stellt der parallel zum Widerstand R13 - mit einem Wert von typisch Kiloohm - liegende eingeschaltete Transistor N13 einen niederohmigen Parallelpfad bereit, der die über C_{DG} eingekoppelte Störung auf das Gate von ST nach VSS ableitet und somit im ausgeschalteten Zustand lässt.

Bei einer Ausführung der Widerstände R11 bis R13 als Diffusionswiderstände, die eine nicht-lineare Spannungs-Strom-Kennlinie haben, nimmt der Widerstand mit zunehmendem Strom zu. Im Fall langsamer Störungen und einer kapazitiven Stromkopplung über C_{DG} auf das Gate von ST gewinnt der im durchgeschalteten Zustand niederohmige Transistorzweig durch N12 mit zunehmendem Strom mehr Einfluss und begünstigt die Störungsunterdrückung.

Im Gegensatz zu den langsamen Störungen kann bei schnellen ESD-Störungen zusätzlich zu der Einkopplung über C_{DG} auf das Gate von ST ein Störanteil direkt auf das Gate des Schutztransistors ST gekoppelt werden. Dann kann, bevor der Inverter aus P12 und N12 umschaltet, der zunächst noch niederohmige Transistor N12 das Gate von ST nicht mehr stabilisieren und auf VSS halten. Dies ist jedoch günstig, weil der Transistor ST durch diesen parasitären Effekt quasi vorgespannt wird, bevor er durch die ESD-Detektion der Ansteuerschaltung, durch die die Inverter umschalten, aktiviert wird. Der Einsatz von Diffusionswiderständen beschleunigt deshalb die Wirkung der Schutzschaltung und verbessert diese zusätzlich.

Im Fall des power-on hat die Schaltungsanordnung nach Figur 2 und insbesondere nach Figur 3 den Vorteil, dass die Widerstände R11 bis R13 mit den Invertern ab Beginn des power-on definierte "aus"-Zustände bereit stellen, die den Transistor ST ausgeschaltet lassen. Eine Schwingung durch einen schnell schaltenden Transistor ST, wie sie bei bekannten Schaltungen durch undefinierte Zustände möglich ist, kann dadurch vermieden werden. Damit kann gemäß Figur 3 ein schnellerer power-on erfolgen und der Schaltungseinrichtung eine erweiterte Anwendung ermöglichen.

## Patentansprüche

1. Schaltungsanordnung zum Schutz von integrierten Halbleiterschaltungen vor elektrischen Pulsen oder elektrischen Überspannungen mit
- einem RC-Element aus einem ersten Widerstand (R1; R10) und einer Kapazität (C1; C10), das zwischen zwei Versorgungspotentialleitungen (VDD, VSS) geschaltet ist,
- einer Kette aus hintereinander geschalteten Invertern (I10
- I12), die eingangsseitig mit dem Verbindungspunkt des ersten Widerstands (R1; R10) und der Kapazität (C1; C10) verbunden ist, und
- mit einem Schutztransistor (ST), der an seinem Steuereingang mit dem Ausgang der Inverterkette verbunden und ausgangsseitig mit den zwei Versorgungspotentialleitungen (VDD, VSS) verbunden ist, **dadurch gekennzeichnet,**
**dass** die Verbindungspunkte der Inverter (I10 - I12) untereinander und mit dem Schutztransistor (ST) jeweils mit einem Widerstand (R11, R12, R13) verbunden sind, wobei die Widerstände an ihrem jeweils anderen Anschluss mit einer der Versorgungspotentialleitungen (VDD, VSS) verbunden sind.

2. Schaltungsanordnung nach Anspruch 1, **dadurch gekennzeichnet,**
**dass** die Widerstände wechselseitig mit je einer der Versorgungspotentialleitungen (VDD, VSS) verbunden sind.

3. Schaltungsanordnung nach Anspruche 1 oder 2, **dadurch gekennzeichnet,**
**dass** der Eingang des letzten Inverters (I12) der Inverterkette über einen der Widerstände (R11) mit der einen Versorgungspotentialleitung (VDD) und der Ausgang des letzten Inverters (I12) der Inverterkette über einen anderen der Widerstände (R12) mit der anderen Versorgungspotentialleitung (VSS) und mit dem Steuereingang des Schutztransistors (ST) verbunden ist.

4. Schaltungsanordnung nach einem der Ansprüche 1 bis 3, **dadurch gekennzeichnet,**
**dass** die Inverter als CMOS-Inverter (P11, N11; P12, N12; P13, N13) ausgebildet sind.

5. Schaltungsanordnung nach einem der Ansprüche 1 bis 4, **dadurch gekennzeichnet,**
**dass** die Widerstände als Diffusionswiderstände ausgeführt sind.

6. Schaltungsanordnung nach einem der Ansprüche 1 bis 5, **dadurch gekennzeichnet,**
**dass** der erste Widerstand (R10) ein Diffusionswiderstand ist.

7. Schaltungsanordnung nach einem der Ansprüche 1 bis 6, **dadurch gekennzeichnet,**
**dass** die Kapazität (C1; C10) eine Oxidkapazität ist.

## Claims

1. A circuit arrangement for protecting integrated semiconductor circuits from electrical pulses or electrical overvoltages, said circuit arrangement having
- an RC element which comprises a first resistor (R1; R10) and a capacitance (C1; C10) and is connected between two supply potential lines (VDD, VSS),
- a chain of inverters (I10 - I12) which are connected in series, the input of said chain being connected to the junction point between the first resistor (R1; R10) and the capacitance (C1; C10), and
- a protection transistor (ST) whose control input is connected to the output of the inverter chain and whose outputs are connected to the two supply potential lines (VDD, VSS), **characterized in that** the junction points between the inverters (I10 - I12) and between the inverters and the protection transistor (ST) are each connected to a resistor (R11, R12, R13), wherein the respective other connection of the resistors are connected to one of the supply potential lines (VDD, VSS).

2. The circuit arrangement as claimed in claim 1, **characterized in that**
the resistors are alternately connected to each of the supply potential lines (VDD, VSS).

3. The circuit arrangement as claimed in claim 1 or 2, **characterized in that**
the input of the last inverter (I12) in the inverter chain is connected to one supply potential line (VDD) via one of the resistors (R11), and the output of the last inverter (I12) in the inverter chain is connected to the other supply potential line (VSS) via a second resistor (R12) and is also connected to the control input of the protection transistor (ST).

4. The circuit arrangement as claimed in one of claims 1 to 3, **characterized in that**
the inverters are in the form of CMOS inverters (P11, N11; P12, N12; P13, N13).

5. The circuit arrangement as claimed in one of claims 1 to 4, **characterized in that**
the resistors are in the form of diffusion resistances.

6. The circuit arrangement as claimed in one of claims 1 to 5, **characterized in that**
the first resistor (R10) is a diffusion resistance.

7. The circuit arrangement as claimed in one of claims 1 to 6, **characterized in that**
the capacitance (C1; C10) is an oxide capacitance.

## Revendications

1. Montage de circuits destiné à protéger des circuits de semi-conducteurs intégrés contre des impulsions électriques ou des surtensions électriques, comprenant :
- un élément RC constitué d'une première résistance (R1 ; R10) et d'une capacité (C1 ; C10) et connecté entre deux conducteurs de potentiel d'alimentation (VDD, VSS),
- une chaîne constituée d'inverseurs connectés les uns derrière les autres (I10 - I12) et reliée en entrée au point de liaison de la première résistance (R1 ; R10) et de la capacité (C1 ; C10), et
- un transistor de protection (ST) relié par son entrée de commande à la sortie de la chaîne d'inverseurs et en sortie aux deux conducteurs de potentiel d'alimentation (VDD, VSS),
**caractérisé en ce que**
les points de liaison des inverseurs (I10 - I12), entre eux et avec le transistor de protection (ST), sont reliés respectivement à une résistance (R11, R12, R13), les résistances étant reliées par leur autre connexion respective à l'un des conducteurs de potentiel d'alimentation (VDD, VSS).

2. Montage de circuits selon la revendication 1,
**caractérisé en ce que**
les résistances sont chacune reliées réciproquement à un des conducteurs de potentiel d'alimentation (VDD, VSS).

3. Montage de circuits selon la revendication 1 ou 2, **caractérisé en ce que**
l'entrée du dernier inverseur (I12) de la chaîne d'inverseurs est reliée par l'une des résistances (R11) à l'un conducteur de potentiel d'alimentation (VDD) et la sortie du dernier inverseur (I12) de la chaîne d'inverseurs est reliée par une autre des résistances (R12) à l'autre conducteur de potentiel d'alimentation (VSS) et à l'entrée de commande du transistor de protection (ST).

4. Montage de circuits selon l'une des revendications 1 à 3, **caractérisé en ce que**
les inverseurs sont configurés comme inverseurs CMOS (P11, N11 ; P12, N12 ; P13, N13).

5. Montage de circuits selon l'une des revendications 1 à 4, **caractérisé en ce que**
les résistances sont réalisées comme résistances de diffusion.

6. Montage de circuits selon l'une des revendications 1 à 5, **caractérisé en ce que**
la première résistance (R10) est une résistance de diffusion.

7. Montage de circuits selon l'une des revendications 1 à 6, **caractérisé en ce que**
la capacité (C1 ; C10) est une capacité à oxyde.
